# EUROPEAN PATENT APPLICATION

(11) **EP 2 200 082 A1**
(43) Date of publication of application: **23.06.2010**
(21) Application number: 09171464.2
(22) Date of filing: 28.09.2009
(51) Int. Cl.: H01L 27/142, H01L 31/0224, H01L 31/18

(54) **Modular interdigitated back contact photovoltaic cell structure on opaque substrate and fabrication process**

(30) Priority: 19.12.2008 IT VA20080067
(71) Applicant: STMicroelectronics Srl, 20041 Agrate Brianza (MB) (IT)
(72) Inventor: Camalleri, Cateno Marco, 95125, Catania (IT); Lorenti, Simona, 95129, Catania (IT); Mangano, Fabrizio, 95129, Catania (IT)
(74) Representative: Pellegri, Alberto

(57) **Abstract**

A back contacted photovoltaic cell composed of an integrated diode structure of polycrystalline silicon (briefly polysilicon) or in any case of silicon in a at least partially crystalline state, processed according to a so called thin film technology, that is not requiring the use of silicon wafer or of multi micron-thick layers of silicon wafer separated from a mother wafer, and a relative process of fabrication, are disclosed.

## Description

The present disclosure relates in general to thin film photovoltaic cells for converting solar radiation (solar cells) formed at the surface of a substrate and in particular to back contacted vertical cells and related fabrication processes.

### DISCUSSION OF PRIOR ART

Solar cells are conversion devices of solar radiation to electrical energy. In general the cells are made by forming P-type regions and N-type regions in a semiconductor material (photodiodes). The solar radiation, by illuminating the cell, generates electron/vacancy pairs that migrate respectively towards the P-type region and the N-type region, creating a voltage difference at the diode terminals.

In a back contacted solar cell, both N-type doped and P-type doped regions, commonly interdigitated between each other, as well as the current collecting electrodes respectively connected to them that may also form the connecting terminals of a cell to an electric load using the generated energy, are all defined at the back of a semiconductor wafer, which is normally as thin as possible in order to minimize the required amount of expensive semiconducting material (typically silicon).

An advantage of back contacted solar cells is the absence of opaque conducting metal structures and/or of significantly opacizing diffusions at the front of the wafer, though the surface of which enters the solar radiation.

There are innumerable types of solar cells, an important technological divide is that among solar cells defined on a wafer of semiconductor material (commonly of polycrystalline or monocrystalline silicon) and so called thin film solar cells that may be formed over a purely mechanical supporting substrate through deposition, patterning and/or phase segregation/transformation, doping and other treatments of conducting, dielectric and semiconducting films, commonly of thickness in the order of nanometers up to few thousands of nanometers.

The particularly advantageous aspects of thin film cells under the economical aspect, is a dramatic reduction of the quantity of valuable materials, in particular of semiconductors, that are required compared to solar cells formed on classical monocrystalline or polycrystalline semiconductor substrate that by far represents the most relevant cost element, also in consideration of the rather low yield per unit area of common solar panels (that is of photovoltaic conversion devices not of concentration type).

In any case, it remains an important efficiency parameter the ratio between active area and total area of the panel tied to the opaque footprint of a current collecting metal grid that may be present on the front (illuminated surface) of the panel, to which must be added an area, also unavailable for conversion, because dedicated to the formation of isolations among adjacent cells and interconnections the numerous cells or multicellular wafers arranged over a relatively ample surface of a panel, according to a certain series-parallel scheme as electrical connection.

In order to reduce the amount of unused area, instead of connecting the unit cells among each other according to a design series-parallel scheme of the multicellular panel already during monolithic integration of the cells on the substrate, a post-isolation and/or post-connection of the unit cells may be performed by laser scribing. Laser scribing may even be done through the same substrate if it is of a transparent material or through the wafer front or stack of thin layers deposited and processed onto the substrate surface. However the laser scribing technique of localized fusion, may augment crystal lattice defectivity which, though localized, may sensibly penalize conversion efficiency, by causing more or less diffused short circuits among distinct electrical structures of the integrated photodiode.

In general, there is the need of optimizing the architecture of integrated photovoltaic structures by stricking the best compromise between sensibly incrementing the unused area by realizing electrodic structures of high contact density for minimizing intrinsic (parasitic) resistance of the single cells or admitting a higher intrinsic resistance and favoring a reduction of the unused area.

As already mentioned, the architectures of photovoltaic cells in which both electrodic structures of electrical contact and termination of each cell (that in the present context must be intended also as cell module or generally any elementary module replicable over the extended surface of the panel) are formed at the back of the cell offer decisive advantages in enhancing area exploitation.

On the other end, efficiency and fabrication costs remain fundamental marketing parameters of a solar panel in an extremely competitive commercial context among different renewable and non renewable energy sources, therefore solar cell structures of enhanced yield and reduced costs of fabrication are constantly object of developments and technological advances.

A novel and efficient back contacted solar cell structure and an effective process of fabrication that lends itself to the formation of interconnected arrays of cells according to a desired series-parallel scheme, directly over substrates of relatively large dimension, using simple and low cost techniques industrially usable for producing efficient and low cost panels of large sizes, are herein disclosed.

### SUMMARY OF THE INVENTION

The present disclosure concerns a back contacted photovoltaic cell composed of an integrated diode structure of polycrystalline silicon (briefly polysilicon) or in any case of silicon in a at least partially crystalline state, processed according to a so called thin film technology, that is not requiring the use of silicon wafer or of multi micron-thick layers of silicon wafer separated from a mother wafer.

The integrated photodiode structure is defined, according to a common interdigitated architecture, by alternated P-type and N-type doped regions in the form of adjacent parallel stripes (fingers) of a polysilicon film, spaced and isolated one from the other by intervening narrow stripes of undoped polysilicon, and in electrical contact with underlying metal stripes or fingers of coincident interdigitated electrode structures of back contacting and electrical termination of the cell (integrated photodiode) defined over the surface of a mechanical substrate having at least a dielectric superficial region or surface coat.

A semiconducting silicon layer, at least partially crystalline, of thickness generally greater that the thickness of the underlying interdigitated stripes of doped polysilicon, such to maximize absorption therein of photonic energy, covers the interdigitated p⁺ and n⁺ regions, acting as photonic energy absorption region of the diode. This absorption region may even be slightly doped with a p-type dopant or a n-type dopant, or left with its intrinsic electrical characteristics depending on the peculiarities of the integration process and of the material used.

Depending on the characteristics of the materials used, it may be useful to top the absorption layer with a thin film of at least partially crystalline silicon, doped with the same time of conductivity of that of the underlying absorption layer, such to confer to the topping film of polysilicon a relatively high electrical conductivity the function of which is to contrast recombination of mobile vacancies and electrons generated in the underlined absorption region by absorption of photonic energy.

The spacing/isolating stripes of undoped polysilicon between adjacent p⁺ and n⁺ doped regions, effectively isolate laterally adjacent active regions of opposite type of conductivity, minimizing efficiency losses in the process of conversion of the photonic energy in the blanket layer of semiconducting polysilicon that acts as intrinsic semiconductor of the integrated structure of the photodiode, that may be defined of multijunction type and, for some peculiarities, similar to a *pin* or *nip* structure, equating the absorption layer to the intrinsic semiconductor region *i* or the pin or nip diodes of photovoltaic cells of amorphous silicon.

Preferably, an anti-reflecting surface film may also be present, for example a film of hydrogenated silicon nitrate, of thickness in the order of 1 or few hundreds of nanometers.

The active p⁺ and n⁺ polysilicon regions constituting the interdigitated anode (p⁺) and cathode (n⁺), respectively of the integrated diode structure, may be formed starting from a blanket layer of hydrogenated amorphous silicon, by printing for example with serigraphic, tampographic or inkjet printing techniques, a layer of a donor material of the dopant species, for example boron for doping and crystallizing hydrogenated amorphous silicon to a p⁺ doped polysilicon, or for example phosphorous for doping and crystallizing hydrogenated amorphous silicon to an n⁺ doped polysilicon.

Alternatively, it is possible to apply the donor material by CVD deposition or pre-deposition, using suitable precursors such as for example: POCl₃, BCl₃, boron nitrate and the like. In this case, masking steps of the non doped regions and successive removal of the masked materials and of the residues of the deposited donor material at the end of the doping process, are necessary.

Doping of silicon by diffusing dopant from a printed donor layer into the hydrogenated silicon accompanied by release of hydrogen, may be conducted, preliminarily in an oven or by laser beam activation or by luminating the printed surface with non monochromatic light from flash lamps and alikes.

Alternatively diffusion of the dopant may take place during the heat treatment that is done for transforming the deposited amorphous silicon in polycrystalline silicon, preferably under treatment conditions that favor the growth of crystal grains of large sizes (in the order of tenth of a micrometer up to several tens of micrometers).

The novel interdigitated back contacted integrated photodiode cell structure may be economically and easily fabricable even on large size substrates for realizing arrays of a theoretically unlimited number of cells, the electrical terminations of which may be pre-ordinately interconnected according to a certain series-parallel scheme over the surface of the substrate, being all geometrical details of the integrated structure definable with techniques applicable to substrates of large size, such as of deposition, heat treatment, laser scribing steps, printing and lithography.

These features of the present invention will become apparent to any person with ordinary knowledge of the specific technical field, by reading through the whole detailed description herein provided that refers to a number of drawings in order to facilitate comprehension and practice of this invention.

### BRIEF DESCRIPTION OF THE DRAWINGS

**FIG. 1** is a cross sectional schematic view of an integrated interdigitated solar cell structure according to an embodiment of this invention.
**FIG. 2** is a layout view of the interdigitated integrated cell structure of FIG. 1.
**FIG. 3** is a layout of a photovoltaic panel composed by four integrated cells in series.
**FIG. 4** is a schematic cross section showing a technique of post-connection and isolation of a number of cells in series for constituting a multicellular module.

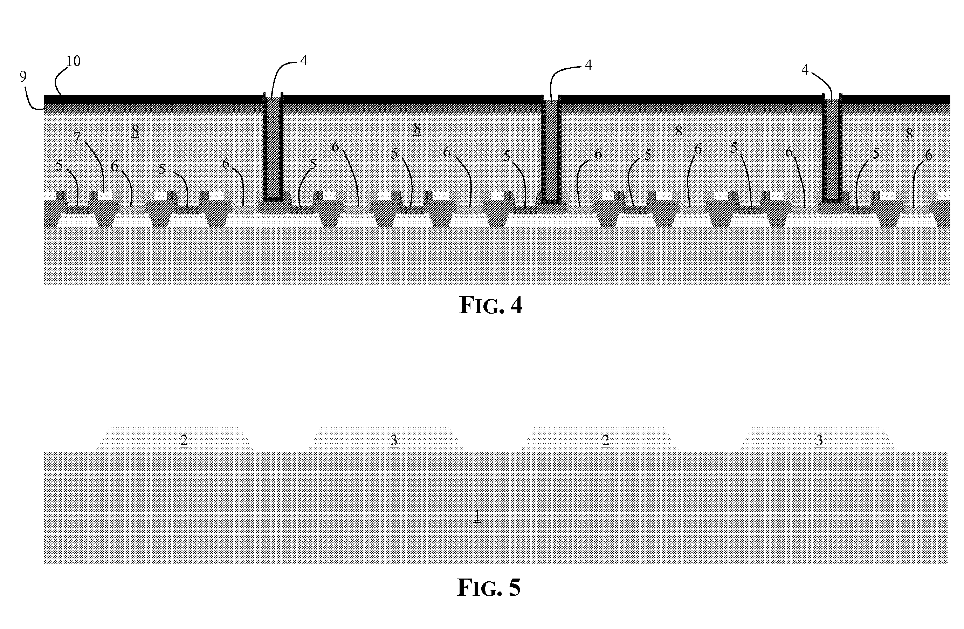

The series of **FIG. 5-12** illustrates main steps of a fabrication process of the integrated cells of this invention.

### DESCRIPTION OF THE EMBODIMENTS OF THE INVENTION

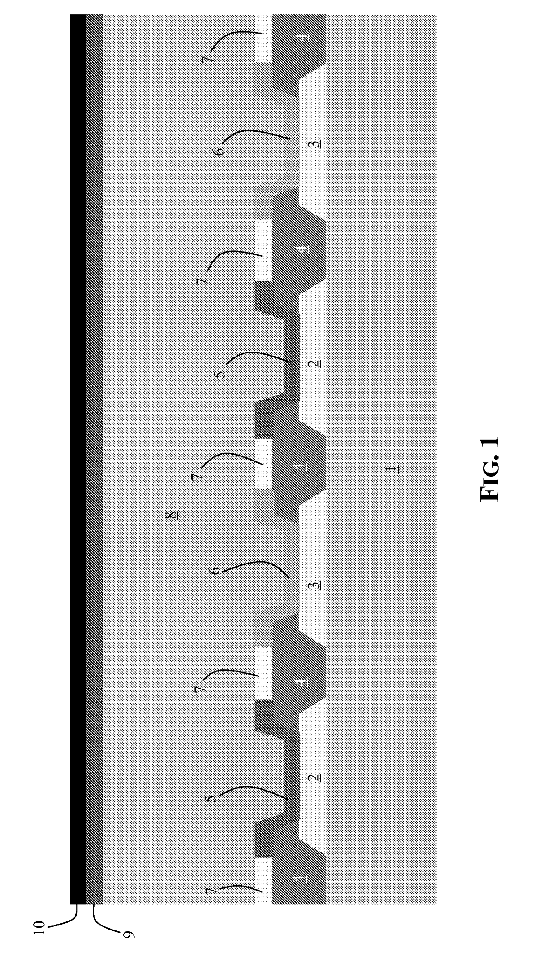

An exemplary embodiment of the novel integrated structure of a polycrystalline silicon diode or of least partially crystalline silicon at of the photovoltaic cell of this disclosure is shown in the partial cross sectional view of **FIG. 1****.**

The mechanical supporting substrate 1 maybe of any metallic, ceramic or glass-ceramic material suitable to withstand process temperatures, of maximum value that ranging from about 600 to about 1.000°C and possibly up to about 1.200°C or even higher.

Examples of suitable materials are titanium, the surface of which may be rendered electrically insulating by growing a surface oxide film, anodized aluminum (suitably limiting the maximum process temperature), sheet copper, nickel, stainless steel or hastelloy provided with a ceramic coat, ceramic or glass-ceramic plates.

Two distinct interdigitated electrode structures 2 and 3 of back contact and electrical connection of the cell may be made of the same metallic material, adapted to resist the process temperature necessary to the formation of the integrated diode structure without significantly compromising characteristics of electrical conduction. An example of suitable material meeting these requisites is molybdenum which is by far the metal more used for making current collecting structures on large thin film solar panels based on CIS (copper-indium-selenide) or CIGS (copper-indium-gallium-selenide).

Deposition of a layer of adequate thickness, commonly between 10 and 100 or more micrometers, can be carried out by chemical phase deposition, sputtering, printing or other suitable technique.

The separation gaps between adjacent parallel metal stripes of the two interdigitated electrode structures may be filled with a dielectric material 4, typically an oxide, as for example SiO₂ or Al₂O₃, though other oxides may be used.

The dielectric 4, as shown in FIG. 1, is defined such to let it overhang above the upper edges of the metal stripes 2 and 3, such to define active areas directly on the electrode stripes 2 and 3, depressed by a depth that may be comprised between few hundreds of nanometers up to not more than 100-150 micrometers, from the salient crests of the isolation dielectric layer 4.

The active regions of n⁺ doped polysilicon 5 and the active regions of p⁺ doped polysilicon 6 are formed directly above the respective electrode stripes 2 and 3 and in electrical contact with the same, in a deposited mother layer of hydrogenated amorphous silicon (A-SI:H) of thickness that may generally be comprised between a minimum of about 30-50 nanometers and a maximum of about 150-200 nanometers. Stripes 7 over the stripes of dielectric oxide 4 of undoped polysilicon separate and electrically the adjacent stripes of doped silicon 5 and 6 isolate.

The wavy profile assumed by the deposited silicon mother layer, from which by differentiated doping and crystallization parallel active regions 5 and 6 and isolation regions 7 are formed, favors application of a relatively thick layer of donor material of the dopant species in the depressed areas by an appropriate printing technique, for example by serigraphy, tampography or inkjet almost exclusively over the flat bottom of the depressed areas of the surface of the mother layer, by filling at least in part the depressions. In this way, separation of n⁺ and p⁺ regions of the integrated diode structure is reliably secured by the presence of separation stripes 7 of undoped polysilicon as well as by a reduced dopant concentration in the salient portions of the mother layer and those immediately superimposed onto the dielectric oxide 4 which may occur only in a limited measure by the diffusion of the dopant in a lateral direction relative to the thickness of the mother layer, according to a fabrication process that will be described in greater detail later on.

The blanket layer 8 of polycrystalline or at least partially crystallized silicon may have a conductivity of type N or P or even intrinsic. It constitutes the photonic energy absorption region of the integrated interdigitated structure of photovoltaic cell of the present invention.

The thickness of the photonic energy absorption layer 8 is adapted to maximize absorption of solar light and generally may vary between few hundreds of nanometers up to several tens of micrometers and even surpass 100 micrometers. In general, the thickness of the absorption layer 8 should not be greater than five to ten times the diffusion length of carriers within the absorption layer. The diffusion length is function of characteristics of the absorption region in terms of carrier mobility and lifetime of the carriers that are generated in the material and to this end, the fabrication process, as will be illustrated later, should strive to maximize these parameters through specific optimization treatments for improving the crystallographic structure of the absorption region layer 8, and/or for passivating active crystal defects that would act as centers of generation/recombination of carriers.

A superficial layer 9 of thickness generally in the order of tens of nanometers up to few hundreds nanometers, the doping of which should be of the same type of conductivity of the underlying absorption region 8, and such to confer to the relatively thin superficial layer 9 a relatively high electrical conductivity is preferably included in the structure, in order to contrast recombination of mobile carriers (vacancy and electrons) that are generated in the underlying region 8 of lesser dopant concentration upon absorbing photonic energy. The conductive superficial layer favors migration of the majority of the generated carriers towards the respective doped regions 5 and 6 of the integrated photodiode structure.

Preferably, an optional anti-reflective film 10 may also be present, for example of silicon nitride, titanium oxide or silicon. Generally, the thickness of this anti-reflective surface film does not exceed 500 nanometers.

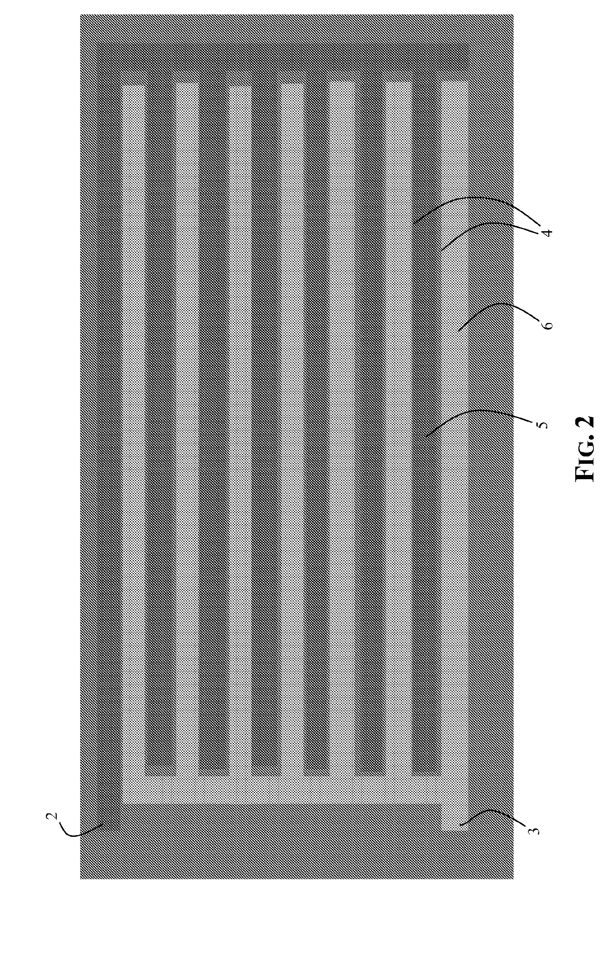

FIG. 2 is a layout of an integrated photovoltaic cell in which is clearly observable the interdigitation of fingers of active regions of N-type 5 and of P-type 6 and of the isolation dielectric 4 through the transparent layers 8, 9 and 10 of the structure of FIG. 1.

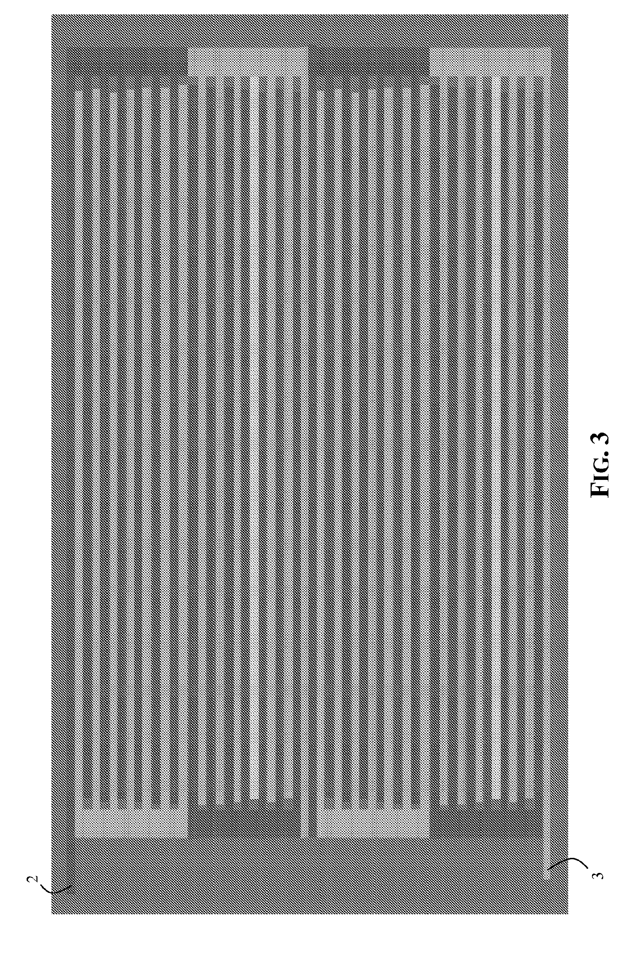

FIG. 3 is an exemplary layout of a module, composed of four integrated photovoltaic cells electrically connected in series, that can be reproduced innumerable times in order to cover the whole area of a solar panel of large dimensions, having a plurality of such modules electrically connected according to a certain design series-parallel scheme.

FIG. 4 shows how single cells and/or single modules part of a chain of cells or modules electrically in series may be structurally isolated and thus be connected according to a certain series-parallel scheme that may be already pre-established during patterning of the metal layer 2-3, through a post isolation step of integrated cells that contemplates a deep trench cut by laser beam or through a masked plasma etch of the transparent surface layers 10, 9 and absorption region 8, forming trenches 4 that may then be filled with an appropriate dielectric.

Solely for illustrative purpose, an exemplary process of fabrication of a back contact, interdigitated thin film photovoltaic cell of the present disclosure will be described in details.

The series of figures from FIG. 5 to FIG. 12 illustrates only the main and significative steps of the fabrication process, which may be conducted with techniques commonly used in the industry.

FIG. 5 shows the cross-section that is obtained upon concluding the first step of deposition on the surface (of dielectric properties) of the substrate 1, of a layer of uniform thickness of a metal adapted to establishing a good electrical contact with doped polysilicon that is defined by etching though the openings of a mask of resist or oxide or any other suitable masking material, that can be formed or applied onto the surface by an appropriate printing technique (serigraphic, tampographic, inkjet), and The parallel stripes 2 and 3 belong to two distinct interdigitated current collecting electrodes of termination of the integrated structure of the photovoltaic cell being fabricated.

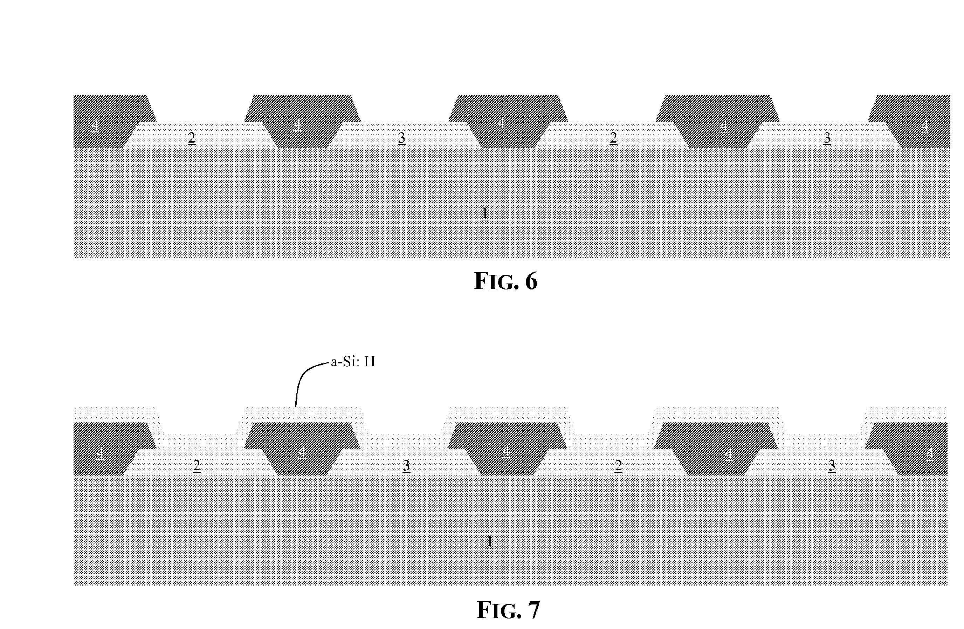

FIG. 6 shows the cross-section obtained at the end of a phase which after removal of the masking material used for defining the interdigitated electrodic structures 2 and 3 contemplates first a planarising deposition of a dielectric layer adapted to fill the interstices between adjacent metal stripes 2 and 3. The dielectric may be an oxide or an oxy-nitride or nitride, for example SiO₂, and deposition is continued as far as obtaining a deposited layer with a substantially planar surface. Thereafter the dielectric is removed from active areas through a photolithographic process or with subtractive printing technique or by depositing only in the desired areas the dielectric material by additive techniques (such as printing, deposition over shadow mask, and alike).

In case of blanket deposition of the dielectric, this second masking step that can be also carried out with a printing technique which (serigraphic, tampographic or inkjet) a masking layer of resist or of any other material capable of withstanding the etching solution of the dielectric is formed onto the planarized surface, through the openings of which the active areas of the integrated structure are defined directly above the respective metal electrodes 2 and 3, from where the dielectric is etched off completely, thus leaving isolation stripes 4 of dielectric which to some extent overstep the upper edges of definition of the metal stripes 2 and 3 by a height that may be comprised between few hundreds of nanometers up to about a hundred micrometers from the plane of the metal stripes 2 and 3.

As shown in FIG. 7, after having eventually removed any residue of the mask material and leached off the native oxide from the exposed surfaces of the metal stripes 2 and 3, a mother layer of silicon, preferably undoped, such as for example a layer of hydrogenated amorphous silicon (A-SI:H) or of silicon only partially crystalline, is deposited under conditions of highly conformal deposition, over the whole surface, that is besides over the defined active areas in contact with the exposed surfaces of the electrode structures 2 and 3, also over the salient stripes of isolation dielectric 4. Deposition of the mother layer of silicon maybe carried out according to any of the commonly used techniques of conformal deposition, for example by RF-PECVD DC-PECVD VHS PECVD, Microwave-PECVD, sputtering, Photo-CVD or Hot-wire.

RF-PECVD and DC-PECVD are particularly suitable techniques for obtaining a deposited silicon layer highly conformal to the wavy prophile of the surface receiving the deposit.

The thickness of the mother layer of silicon may generally be comprised between few tenth of nanometers up to few tenth of microns even little more, depending on the doping technique that is intended to be used.

After having deposited the mother layer of silicon, by any appropriate printing techniques, pastes or inks stripes 11 and 12, containing substances rich of the specific dopant species, respectively (for example boron for P-type doping or for example phosphorous for N-type doping), over the areas of regions of the mother layer of silicon that will be converted respectively to n⁺ doped polycrystalline silicon 5 and to p⁺ doped polycrystalline 6.

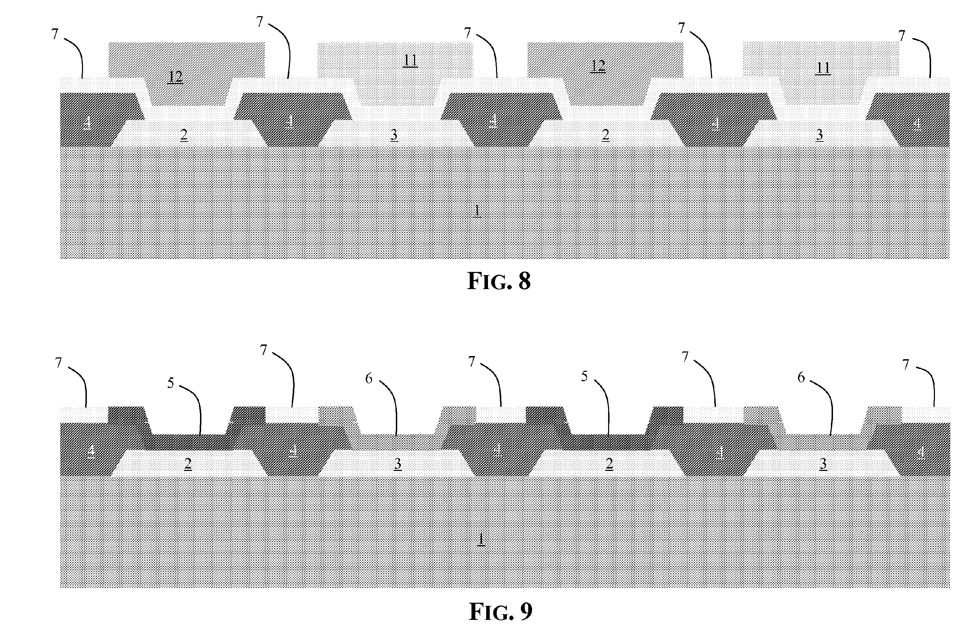

FIG. 8 illustrates the application of layers of paste or ink donor of either p-type dopant 11 and of n -type dopant 12, over active areas geometrically topping the metal stripes 3 and 2 of the respective electrodes. Application of the donor substances 11 and 12 may be carried out with an appropriate printing technique such as serigraphic, tampographic or inkjet. Serigraphy and tampography are printing techniques particularly suited and adapted to favor deposition of a relatively thick layer of donor substance of the drogant species over the bottom of the parallel extending depressed areas of the mother layer of hydrogenated amorphous silicon A-SI:H.

The donor substances 11 and 12, respectively printed over active areas to be formed of p-type and of n-type and therefore adapted to make p-type dopant (for example boron) or n-type dopant (for example phosphorous) to the underlying silicon of the mother layer, may be commercial serigraphic pastes produced by the companies Ferro or by E.I. Du Pont de Nemours, chosen in function of the relative successive curing technique (heat treatment or UV).

FIG. 9 shows the cross-section of the integrated structure being fabricated after having diffused in the silicon of the mother layer the dopant species of p-type and of n-type from the respective donor pastes or inks printed over the alternated parallel active area projectively over the respective metal lines 3 and 2 of the distinct electrode structures and after having removed the residues of the donor substances applied by printing from the surface of the amorphous silicon mother layer.

During the heat treatment of diffusion and activation of the dopant species of n-type in the areas 5 and of p-type in the areas 6 of the conformally deposited silicon mother layer, for example of hydrogenated amorphous silicon that during the heat treatment of diffusion releases the hydrogen contained therein, a substantial crystallization of the silicon is produced which therefore transform itself in a n+ doped polysilicon in regions 5, in a p+ doped polysilicon in regions 6, while remaining substantially undoped and practically not electrically conductive in the regions 7 above the underlying stripes 4 of dielectric material.

At treatment temperature of diffusion and activation of the dopant exceeding the transition temperature from the amorphous phase to crystalline phase of the silicon, formation of crystalline grains and/or growth of crystal dominus that may be present in the deposited silicon takes place.

During the heat treatment, the silicon if deposited in hydrogenated amorphous form releases hydrogen and a simultaneous diffusion and activation of the dopant takes place.

It is possible to employ common ovens as well as optical apparatuses monochromatic (laser) or polychromatic (flash lamps) for carrying out diffusion/activation and crystallization.

Compatibly with the overall integration process, the heat treatment of diffusion activation and crystallization may even become part of the doping step itself, by introducing in the treatment chambers suitable precursors of the dopant species. In this case, though it may be necessary to form suitable masks over the deposited mother layer of silicon in order to localize distribution of the relevant donor material.

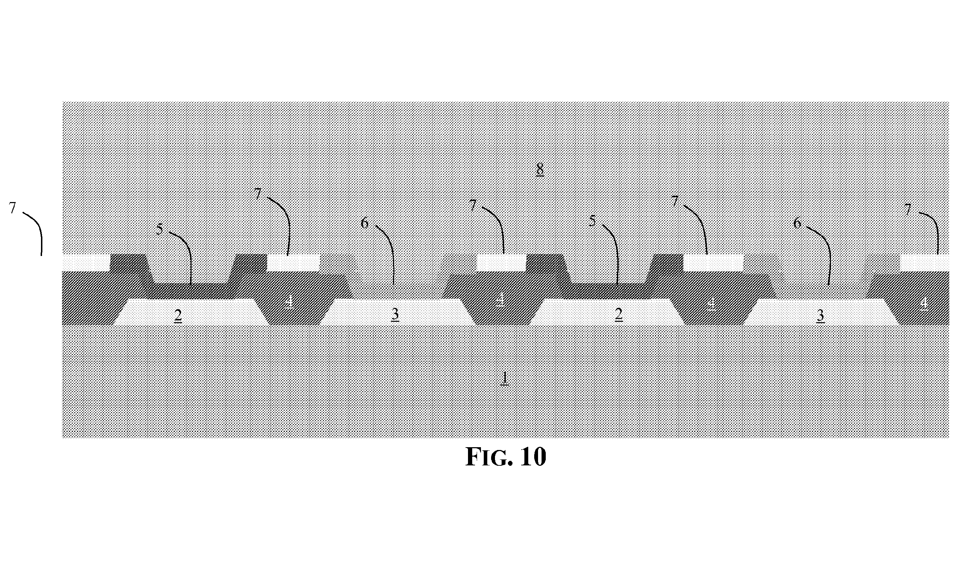

FIG. 10 shows the cross section obtained after depositing a photonic energy absorption layer 8 which in the considered exemplary embodiment is of N-type polysilicon (slightly doped n⁻ silicon with a dopant concentration not exceeding 1x10¹⁷ atoms/cm³). N-type polysilicon may be deposited for example by a CVD technique in presence of phosphine or arsine, at a temperature comprised between 500 and 1100°C, for a time sufficient to obtain a layer of thickness that may arrange from a bout 100 nm and 100 µm more preferably between 300 and 500 nm, with a concentration of phosphorous not exceeding 5x10¹⁶ atoms/cm³.

In order to ensure an enhanced "continuity" between the doped polysilicon layer and the photonic energy absorption layer 8 of slightly doped polysilicon deposited thereon, the process flow may include a surface pre treatment of the doped polysilicon layer before depositing thereon the polysilicon of the photonic absorption layer 8, in order to eliminate the presence of native oxides or other native compounds on the surface receiving the deposition. Native compounds are always present at the surface of the doped polysilicon layer because of exposition to ambient atmosphere, whether of a storage ambient as well as of the processing atmosphere during the preceding heat treatment steps. Such a surface pre treatment may be a wet treatment using for example a HF solution or in gaseous atmosphere, for example in hydrogen plasma or in presence of molecular or radical hydrogen at high temperature or in vapors of anhidrous HF).

A photonic absorption layer 8 of silicon only partially crystalline and in significant measure in amorphous state may have mobility and/or lifetime values of electrical carriers not entirely satisfactory because of lattice defects existing within crystal grains as well as at boundaries between adjacent crystal grains.

In order to reduce the effects of these defects it may be useful to hydrogenate the deposited silicon layer. In practice, the photovoltaic device been manufactured may be exposed to atmospheres saturated with hydrogen, preferably non molecular hydrogen, and energy may be applied for diffusing hydrogen or a precursor thereof in the polycrystalline lattice of the deposited silicon layer, such to promote passivation of defects by bonding thereto hydrogen or a hydrogen precursor.

Various treatment schemes of the many known in the silicon processing art may be followed, such as for example diffusion of hydrogen from a hydrogenated layer deposited over the surface of the silicon (for example a deposited silicon nitride layer as it may be already contemplated for forming an anti-reflective surface film) with a PECVD technique and therefore rich in hydrogen may be exploited as an effective hydrogen donor, or exposing the article been manufactured to a plasma of hydrogen or of a hydrogen precursor compound. This step may be introduced in the process flow where most appropriate, surely after having carried out crystallization of the silicon of the photonic absorption layer 8, taking into account the shielding in characteristics to hydrogen diffusion that may have more strongly doped surface layers (9) e.g. the diffused layer surface that may be included according to a preferred embodiment of the invention, as disclosed in more detail herein below.

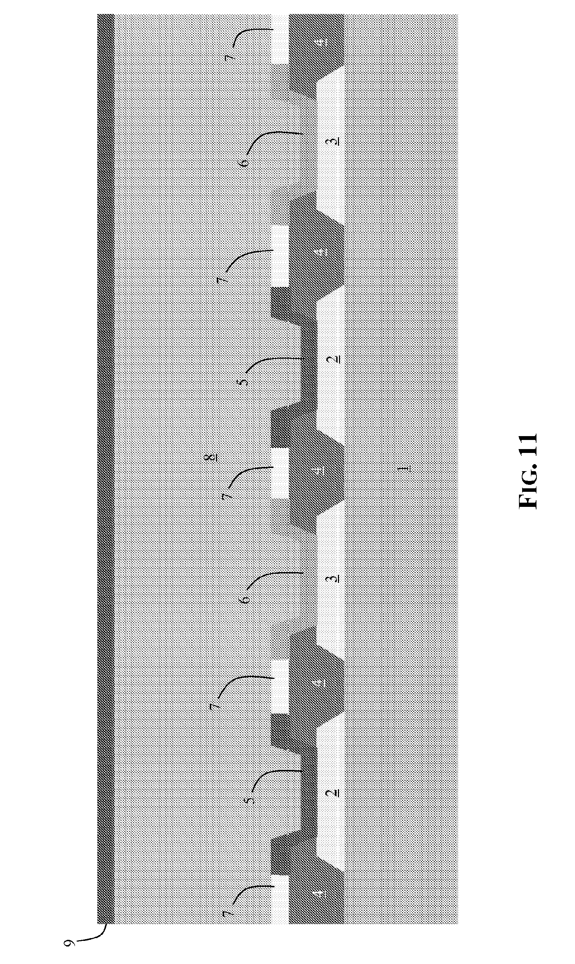

As shown in FIG. 11, over the photonic absorption layer 8 of n⁻ polysilicon, a n⁺ shallow junction diffusion 9 may be formed, of thickness generally not exceeding 200 nm. The junction region 9 is preferably formed by diffusing dopant of the same type of conductivity of the dopant of the absorption region 8 by exposing the surface of the deposited silicon layer to a POCl₃ atmosphere.

The integrated structure thus fabricated may also be further treated at a temperature comprised between 600 and 1000°C, in order to recrystallize the surface junction n-/n+ to which may follow an annealing treatment at a temperature of 900°C for a period comprised between about 30' and 3 hours.

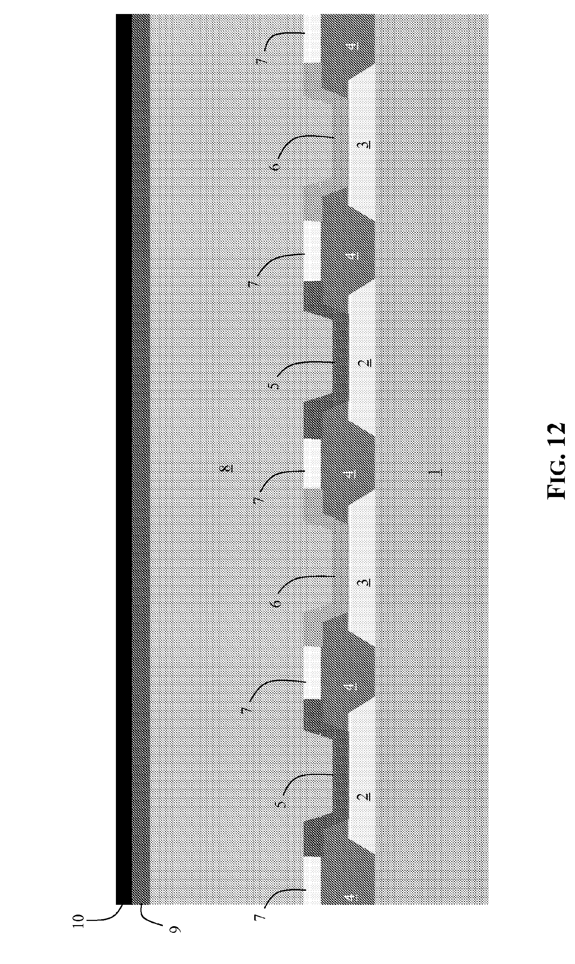

Finally, as shown in the cross-section of FIG. 12, on the front of the device, an anti-reflective film 10 may be deposited, for example a film of silicon nitride of thickness generally not greater than 500 nm, subjected to a hydrogenation treatment according to any of the common techniques used in the field for this purpose.

## Claims

1. Back contact, integrated photovoltaic cell comprising:
a substrate having a dielectric surface;
a patterned metal layer with parallel spaced alternately positive and negative electrode fingers forming an interdigitated two-terminal structure over said dielectric surface of the substrate;
a dielectric filler in the interstices of separation between adjacent spaced parts of said patterned metal layer;
parallel spaced strips, alternately of *p*⁺ doped polysilicon and of *n*⁺ doped polysilicon, topping said positive and negative interdigitated electrode fingers, respectively, and constituting doped p-type active regions and n-type active regions of the integrated photovoltaic cell, spaced and isolated by a strip of undoped or negligeably doped polysilicon;
a *n*⁻ or *p*⁻ doped or intrinsic semiconducting layer of at least partly crystallized silicon, constituting a semiconductor region of thickness adapted to maximize absorption of photonic energy when illuminated by sunlight, covering said interdigitated active doped regions.

2. The integrated photovoltaic cell of claim 1, further including a topping film of doped and at least partly crystallized silicon having the same type of conductivity of the underlying layer and a greater dopant concentration, of electrical characteristics adapted to contrast re-combination of mobile carriers produced by absorption of photonic energy in the underlying absorption region.

3. The integrated photovoltaic cell of claim 1, wherein said doped p-type regions and n-type active regions have thickness comprised between 30 and 200 nm, and are respectively doped with boron and phosphorous.

4. The integrated photovoltaic cell of claim 1, wherein said semiconducting layer, constituting the photonic energy absorbing region is *n*⁻ or *p*⁻ doped or intrinsic and has thickness comprised between 200 nm and 100 µm and said topping film is coherently *n*⁺ or p+ doped and has thickness comprised between 50 and 200 nm.

5. The integrated photovoltaic cell of claim 1, wherein said patterned metal layer is of molybdenum.

6. The integrated photovoltaic cell of claim 1, wherein said dielectric filler is a material belonging to the group composed of SiO₂, Al₂O₃, SiN, and mixtures thereof.

7. The integrated photovoltaic cell of claim 1, wherein said substrate is of a material belonging to the group composed of surface-oxidized Ti, ceramic-coated sheet of Cu, Ni, Al, stainless steel or of a hastelloy, ceramic and glass-ceramic.

8. The integrated photovoltaic cell of claim 1, further including a antireflective film of a material belonging to the group of silicon nitride, silicon oxide and titanium oxide, over the surface of said topping film.

9. A process of fabrication of a back contact, integrated photovoltaic cell of claim 1, **characterized in that** said parallel spaced strips, alternately of *p*⁺ doped polysilicon and of *n*⁺ doped polysilicon, topping said positive and negative interdigitated electrode fingers are realized by diffusing dopants into a deposited layer of hydrogenated amorphous silicon, from substances source of a p-type or n-type dopant, applied onto respective strip areas of the deposited layer of hydrogenated amorphous silicon by printing and simultaneously and/or successively crystallizing the silicon.

10. A process of fabrication of a back contact, photovoltaic cell of claim 2, comprising the steps of:
procuring a substrate having a dielectric surface and capable of withstanding process temperatures of up to 700 - 1.000 °C;
depositing a layer of an lithographically etchable metal withstanding process temperatures of up to 700 - 1.000 °C and adapted to establish electrical contact with silicon;
patterning the metal layer to define said parallel spaced alternately positive and negative electrode fingers of interdigitated electrodes of a two-terminal structure, by a first masking and etching step of the metal;
filling with a dielectric the interstices among spaced parts of the patterned metal layer;
depositing a layer of hydrogenated amorphous silicon of thickness comprised between 30 and 200 nm;
defining footprints of said parallel spaced strips topping the underlying positive and negative interdigitated electrodes, by applying, layers of substances source of the p-type and n-type dopant, by printing over respective strip areas of the deposited layer of hydrogenated amorphous silicon;
diffusing the dopants from the print layers of source substance into the silicon with release of hydrogen from the silicon and crystallizing the amorphous silicon to polysilicon;
removing residues of printed substances and any native oxide from the surface of the layer of poliysilicon alternately doped *p*⁺ and *n*⁺ in parallel spaced strip areas;
depositing an *n*⁻ or *p*⁻ doped or intrinsic semiconducting layer of at least partly crystallized silicon of thickness comprised between 200 nm and 100 µm;
increasing the dopant concentration in a shallow superficial region of said *n*⁻ or *p*⁻ doped or intrinsic silicon layer and forming an electrically conductive shallow superficial *n*⁺ + or *p*⁺ diffused region thereon.
